**Europäisches Patentamt**

**European Patent Office**

**Office européen des brevets**

(19)

(11) Veröffentlichungsnummer: **0 221 402**
**B1**

# (12) EUROPÄISCHE PATENTSCHRIFT

(45) Veröffentlichungstag der Patentschrift:
03.01.90

(21) Anmeldenummer: 86114151.3

(22) Anmeldetag: 13.10.86

(51) Int. Cl.⁴: **H03K 7/06**

(54) Analog-Frequenz-Wandler.

(30) Priorität: 23.10.85 DE 3537711

(43) Veröffentlichungstag der Anmeldung:
13.05.87 Patentblatt 87/20

(45) Bekanntmachung des Hinweises auf die Patenterteilung:
03.01.90 Patentblatt 90/1

(84) Benannte Vertragsstaaten:
AT CH DE FR GB IT LI NL

(56) Entgegenhaltungen:
DE-A- 2 642 397

(73) Patentinhaber: Siemens Aktiengesellschaft,
Wittelsbacherplatz 2, D-8000 München 2(DE)

(72) Erfinder: Windsheimer, Klaus, Dipl.-Ing. (FH),
Pappenheimer Strasse 43, D-8500 Nürnberg(DE)

## Beschreibung

Die Erfindung betrifft einen Analog-Frequenz-Wandler nach dem Ladungskompensationsverfahren, wobei die Integrationsrichtung durch Invertierung des Eingangssignals und gleichzeitiger Invertierung der Referenzstromrichtung periodisch geändert wird.

Die Genauigkeit von Analog-Frequenz-Wandlern wird wesentlich durch die Offset-Spannung und durch die Ladungseinkopplung vorgeschalteter Schalter (auch charge injection genannt) beeinflußt. Der Einfluß der Ladungseinkopplung wird u.a. durch die Schaltfrequenz des entsprechenden Schalters bestimmt. Bei jedem Schaltvorgang wird nämlich eine bestimmte Ladung eingekoppelt, so daß der letztlich maßgebende eingekoppelte Strom der Schaltfrequenz proportional ist. Zur Kompensation der Offsetspannung ist eine Reihe automatisch arbeitender Verfahren bekannt. Die Wirkung der Ladungseinkopplung kann z.B. durch einen Handabgleich aufgehoben werden, was allerdings eine gesonderte Justierung voraussetzt. Außerdem geht in diesem Fall eine Drift der Störgrößen linear in das Meßergebnis ein.

Aus der DE-AS 2 642 397 ist ein Analog-Frequenz-Wandler der eingangs genannten Art bekannt, bei dem Störströme automatisch kompensiert werden. Dabei ist eine Steuerschaltung zur Erzeugung eines periodischen Polaritätssignals vorgesehen, das die Polarität des Meßstroms bzw. der Meßspannung sowie des Referenzstroms zur Ladungskompensation steuert. Dieses Polaritätssignals ändert seinen logischen Wert immer beim gleichen Pegel der Ausgangsspannung des Integrators.

Durch diese periodische Polaritätsumschaltung wird der Einfluß eines einem Meßstrom überlagerten Fehlerstroms auf die Ausgangsfrequenz des Analog-Frequenz-Wandlers weitgehend kompensiert. Gemäß der genannten Auslegeschrift tritt eine vollständige Kompensation des Einflusses eines polaritätsunabhängigen Fehlerstroms auf die Ausgangsfrequenz ein, wenn die Polaritätsumschaltung mit der Ausgangsfrequenz des Analog-Frequenz-Wandlers synchronisiert wird. Allerdings beruht diese Kompensation auf einer statistischen Streuung der Halbperioden der Polaritätsumschaltung, so daß der Einfluß des Fehlerstroms erst nach einer langen Meßperiode kompensiert ist.

Aufgabe der Erfindung ist es daher, einen Analog-Frequenz-Wandler der eingangs genannten Art so auszuführen, daß er schon nach einer kürzeren Meßzeit exakte Meßergebnisse liefert und daß vorteilhafterweise eine Überlagerung von Wechselspannungen auf dem Eingangssignal nicht stört.

Diese Aufgabe wird erfindungsgemäß dadurch gelöst, daß gleichzeitig mit der Änderung der Integrationsrichtung auch der Integrationskondensator umgepolt wird und daß die Änderung der Integrationsrichtung asynchron zu den Ausgangsimpulsen des Analog-Frequenz-Wandlers mit einer konstanten Periode $\Delta T$ erfolgt.

Durch die Umpolung des Integrationskondensators wird dessen Ladung nach einer Änderung der Integrationsrichtung wieder richtig bewertet. Damit kann eine Änderung der Integrationsrichtung im Gegensatz zu dem bekannten Verfahren auch erfolgen, wenn dessen Ladung bzw. Spannung ungleich Null ist. Somit wird die zu den Ausgangsimpulsen des Analog-Frequenz-Wandlers asynchrone Änderung der Integrationsrichtung möglich. Da im Gegensatz zu dem bekannten Verfahren die Fehler nicht erst im statistischen Mittelwert ausgeglichen werden, liegt wesentlich schneller ein exaktes Meßergebnis vor.

Wenn der dem Integrator nachgeschaltete Komparator nicht eine Nullschwelle aufweist, muß er mit einer synchron zur Änderung der Integrationsrichtung umpolbaren Referenzspannung beaufschlagt werden.

Vorteilhafterweise wird die konstante Periode $\Delta T$ durch einen Frequenzteiler von der Grundfrequenz des Analog-Wertes abgeleitet. Dies ist z.B. zweckmäßig bei Elektrizitätszählern, bei denen ein vereinfachter time-division-Multiplizierer ohne invertierenden Verstärker eingesetzt ist. Die in diesem Fall dem Eingangssignal des Analog-Frequenz-Wandlers überlagerte Wechselspannung mit einer Grundfrequenz von 50 Hz führt dann nicht zu Fehlern.

Vorteilhafterweise wird dem Analog-Frequenz-Wandler ein Multiplizierer vorgeschaltet, dessen erste Eingangsgröße über einen Schalter dem Eingang des Analog-Frequenz-Wandlers zugeführt ist und dessen zweite Eingangsgröße über einen Quantisierer und ein Exklusiv-ODER-Gatter den Schalter ansteuert, wobei ein zweiter Eingang des Exklusiv-ODER-Gatter synchron zur Änderung der Integrationsrichtung angesteuert wird. Die erfindungsgemäße Ausführung des Analog-Frequenz-Wandlers ermöglicht die Verwendung eines solchen einfachen Multiplizierers für Wechselgrößen, da die in diesem Fall vom Multiplizierer abgegebenen überlagerten Wechselspannungen nicht stören. Mit dieser Ausführung des Multiplizierers, der ohne Inverter auskommt, entfällt mit Wegfall des Inverters auch dessen Offsetspannung. Außerdem wird im Analog-Frequenz-Wandler nicht nur die charge-injection, sondern auch die Offsetspannung des Integrators kompensiert.

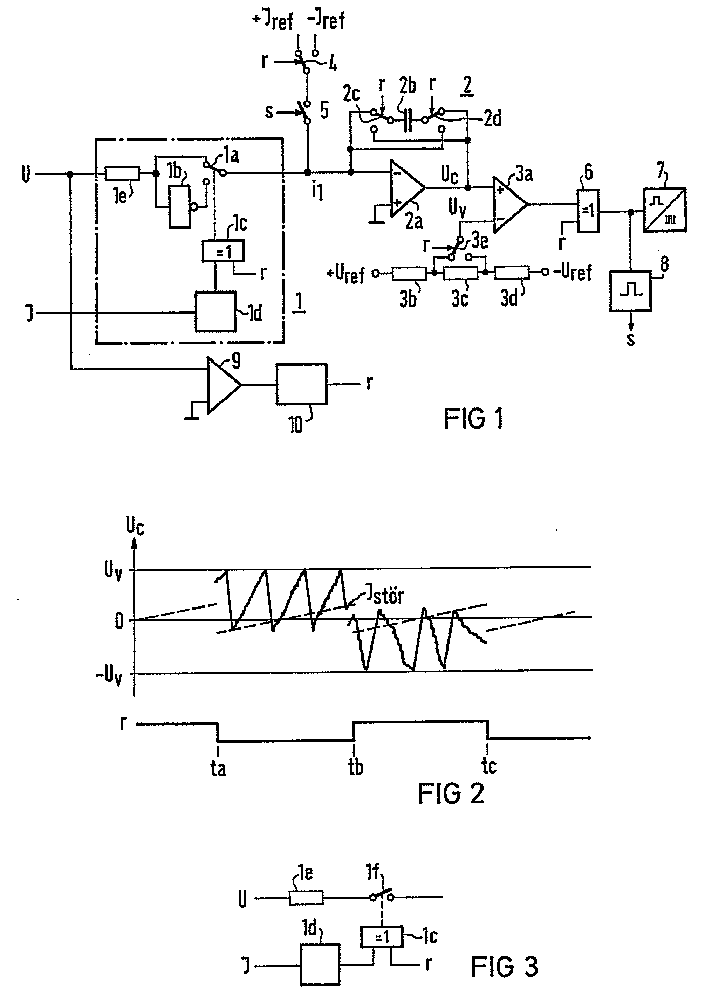

Ein Ausführungsbeispiel der Erfindung wird nachfolgend anhand der Figuren 1 bis 3 näher erläutert:

Fig. 1 zeigt einen elektronischen Elektrizitätszähler als Anwendungsfall für den Analog-Frequenz-Wandler. Dabei wird eine Spannung U und ein Strom I einem Multiplizierer 1 zugeführt. Der Multiplizierer 1 arbeitet nach dem time-division-Verfahren, wie es in der Literaturstelle "Technisches Messen ATM" 1978, Heft 11, Seite 408 beschrieben ist. Dabei wird der Strom I einem in der genannten Literaturstelle detailliert beschriebenen Multiplexer 1d zugeführt, der Impulse mit einer dem Strom I proportionalen Impulsdauer erzeugt. Der Ausgang des Multiplexers 1d ist mit einem ersten Eingang eines Exklusiv-ODER-Gatters 1c verbunden, an dessen zweitem Eingang ein noch zu erläuterndes Signal r ansteht. Die Spannung U wird über einen Widerstand 1e und einen Umschalter 1a je nach Stellung direkt oder mit einem Inverter 1b invertiert zugeführt. Die Stellung des Umschalters 1a wird von dem Exklusiv-ODER-Gatter 1c gesteuert. Am Ausgang des Umschalters 1a steht damit ein Eingangsstrom $i_1$ für den Analog-Frequenz-Wandler zur Verfügung, dessen Mittelwert dem Produkt der Spannung U und des Stroms I proportional ist.

Der Eingangsstrom $i_1$ wird dem invertierenden Eingang des Operationsverstärkers 2a eines Integrators 2 zugeführt. In einem Rückkopplungszweig zwischen Ausgang des Operationsverstärkers 2a und dessen invertierendem Eingang ist ein Kondensator 2b geschaltet, bei dem jeder Anschluß über einen Umschalter 2c bzw. 2d wahlweise an den invertierenden Eingang des Operationsverstärkers 2a oder an dessen Ausgang anschließbar ist. Die Umschalter 2c und 2d werden durch ein Signal r gesteuert, wobei das Signal r eine Umpolung des Kondensators 2b herbeiführt.

Mit einem weiteren Umschalter 4 und einem Schalter 5 ist außerdem wahlweise ein positiver Referenzstrom $+ I_{ref}$ oder negativer Referenzstrom $- I_{ref}$ mit dem invertierenden Eingang des Operationsverstärkers 2a verbindbar. Der Umschalter 4 wird von dem Signal r, der Schalter 5 von einem Signal s gesteuert.

Der nicht invertierende Eingang des Operationsverstärkers 2a ist mit dem Bezugspotential der Schaltung verbunden.

Die Ausgangsspannung $U_c$ des Operationsverstärkers 2a wird dem nicht invertierenden Eingang eines Komparators 3a zugeführt. Zur Bildung einer Vergleichsspannung ist zwischen eine positive Referenzspannung $+ U_{ref}$ und eine negative Referenzspannung $- U_{ref}$ ein Spannungsteiler mit einer Reihenschaltung dreier Widerstände 3b bis 3d gelegt. Über einen Umschalter 3e ist wahlweise der Verbindungspunkt zwischen Widerstand 3b und 3c oder der Verbindungspunkt zwischen Widerstand 3c und 3d an den invertierenden Eingang des Komparators 3a anschließbar.

Über ein Exklusiv-ODER-Gatter 6 ist der Ausgang des Komparators 3a mit einer Zähleinrichtung 7 und einem Impulsgeber 8 verbunden. An einem zweiten Eingang des Exklusiv-ODER-Gatters 6 steht ebenfalls das Signal r an. Der Impulsgeber 8 gibt ein Signal s mit genau defi nierter Länge ab, sobald er eingangsseitig einen Impuls empfängt.

Das Signal r wird durch einen Komparator 9 und einen nachgeschalteten Teiler 10 aus der Spannung U, in diesem Fall der Netzspannung abgeleitet. Dabei gibt der Komparator 9 bei jedem Nulldurchgang der Spannung U einen Impuls auf den Teiler 10, der ausgangsseitig das netzsynchrone Signal r mit einer bezüglich der Netzfrequenz niedrigen Frequenz abgibt.

Die Funktion der dargestellten Schaltung wird im folgenden anhand des Diagramms nach Figur 2 näher erläutert. Dabei wird davon ausgegangen, daß das Signal r zunächst 0 sei. Die vom Multiplizierer 1 gelieferte Spannung $U_1$ wird vom Integrator 2 in positiver Richtung integriert, bis die Ausgangsspannung $U_c$ des Integrators 2 die Vergleichsspannung $U_v$ des Komparators 3a erreicht. Bei Erreichen der Schwellenspannung $U_v$ wird, wie beim herkömmlichen Ladungs-Kompensationsverfahren, ein Impuls an den Zähler 7 abgegeben und gleichzeitig über den Impulsgeber 8 der Schalter 5 für eine definierte Zeit eingeschaltet. Damit wird dem Kondensator eine definierte Ladungsmenge in negativer Richtung zugeführt. Anschließend integriert der Integrator 2 wieder die Ausgangsspannung $U_1$ des Multiplizierers 1 in positiver Richtung. Der während dieser Zeit fließende Störstrom $I_{stör}$ ist in Fig. 2 gestrichelt eingezeichnet, wobei seine Größe allerdings der Sichtbarkeit wegen überproportional gezeichnet ist.

Zu einem Zeitpunkt tb geht das Signal r auf "1". Da nunmehr am Exklusiv-ODER-Gatter 1c an einem Eingang ein "1"-Signal ansteht, wird das an seinem zweiten Eingang anstehende Signal, nämlich das Ausgangssignal des Quantisierers 1d invertiert. Da der Schalter 1a nunmehr auf das invertierte Signal U schaltet, wo er vorher auf das nichtinvertierte geschaltet hätte, bedeutet dies eine Inversion des Ausgangssignals $U_1$. Dieses Signal wird damit nunmehr nach unten integriert. Dadurch, daß mit dem Signal r gleichzeitig auch der Integrationskondensator 2b umgepolt wird, wird dabei eine bei der Signalumschaltung vorhandene Ladung des Integrationskondensators 2b vorzeichenrichtig bewertet, so daß hierdurch kein Fehler entsteht.

Auch die Vergleichsspannung $U_v$ des Komparators 3 wird umgeschaltet und seine Ausgangsspannung durch das mit dem Signal r = 1 beaufschlagte Exklusiv-ODER-Gatter 6 invertiert. Damit wird ein Zählimpuls an den Zähler 7 abgegeben, wenn die Ausgangsspannung $U_c$ des Integrators die untere Vergleichsspannung $-U_v$ erreicht. Gleichzeitig wird über den Impulsgeber 8 wieder ein Impuls definierter Länge an den Schalter 5 abgegeben. Das Signal r = 1 schaltet auch den Umschalter 4 um, so daß in diesem Fall auf den Integrationskondensator 2d eine negative Ladung gegeben wird.

Der Störstrom hat während dieser Betriebsphase seine Richtung nicht geändert. Für die Ladung auf dem Integrationskondensator 2b gilt daher:

$$Q_c = \int\limits_{t_a}^{t_c} (I_{signal} + I_{stör}) \, dt - \int\limits_{t_c}^{t_b} (-I_{signal} + I_{stör}) \, dt$$

wobei gilt: $t_c - t_a = t_c - t_b = \dfrac{\Delta T}{2}$

Dies läßt sich umformen zu:

$$Q_c = I_{signal} \cdot \frac{\Delta T}{2} + I_{stör} \cdot \frac{\Delta T}{2} - (-I_{signal} \cdot \frac{\Delta T}{2})$$

$$- I_{stör} \cdot \frac{\Delta T}{2}$$

Damit ist also:

$$Q_c = I_{signal} \cdot \Delta T$$

d.h. die Kondensatorladung $Q_c$ und damit auch das Meßergebnis sind unabhängig vom Störstrom $I_{stör}$.

Die charge-injection des Schalters 5 und der Umschalter 2c, 2d, 3e und 4 stört nicht, da diese - verglichen mit dem Umschalter 1a - mit niedriger Schaltfrequenz arbeiten.

Das erfindungsgemäße Verfahren läßt sich auch anwenden, wenn der Multiplizierer in einer vereinfachten Form gemäß Fig. 3 aufgebaut ist. In diesem Fall ist nämlich im Unterschied zur Ausführungsform nach Fig. 1 kein Inverter für die Spannung U vorgesehen, sondern diese wird lediglich über einen Schalter 1f gesteuert. Dieser Schalter wird wie bei der Anordnung nach Fig. 1 angesteuert. Auch in diesem Fall liefert die Anordnung richtige Ergebnisse, wenn die Umschaltfrequenz von der Grundfrequenz der zu messenden Spannung abgeleitet ist. Bei einer Ableitung des Signals r aus der Spannung U gemäß Fig. 1 ist dies der Fall.

**Patentansprüche**

1. Analog-Frequenz-Wandler nach dem Ladungskompensationsverfahren, wobei die Integrationsrichtung durch Invertierung des Eingangssignals und gleichzeitiger Invertierung der Referenzstromrichtung periodisch geändert wird,**dadurch gekennzeichnet**, daß gleichzeitig mit der Änderung der Integrationsrichtung auch der Integrationskondensator (2b) umgepolt wird und daß die Änderung der Integrationsrichtung asynchron zu den Ausgangsimpulsen des Analog-Frequenz-Wandlers mit einer konstanten Periode $\Delta T$ erfolgt.

2. Analog-Frequenz-Wandler nach Anspruch 1, **dadurch gekennzeichnet**, daß der dem Integrator nachgeschaltete Komparator (3) mit einer synchron zur Änderung der Integrationsrichtung umpolbaren Vergleichsspannung ($U_v$) beaufschlagt ist.

3. Analog-Frequenz-Wandler nach Anspruch 1 oder 2, **dadurch gekennzeichnet**, daß die konstante Periode $\Delta T$ durch einen Frequenzteiler (4) von der Grundfrequenz des Analogwerts abgeleitet wird.

4. Analog-Frequenz-Wandler nach Anspruch 3, **dadurch gekennzeichnet**, daß ein Multiplizierer vorgeschaltet wird, dessen erste Eingangsgröße (u) über einen Schalter (1f) dem Eingang des Analog-Frequenz-Wandlers zugeführt ist und dessen zweite Eingangsgröße über einen Quantisierer (1d) und ein Exklusiv-ODER-Gatter (1c) den Schalter (1f) ansteu ert, wobei ein zweiter Eingang des Exklusiv-ODER-Gatters (1c) synchron zur Änderung der Integrationsrichtung angesteuert wird.

**Claims**

1. Analog frequency converter based on the charge compensation process, whereby the direction of integration is periodically changed by inversion of the input signal and simultaneous inversion of the direction of the reference current, characterized in that, simultaneously with the change in the direction of integration, the polarity of the integration capacitor (2b) is reversed and in that the change in the direction of integration is effected asynchronously, relative to the output pulses of the analog-frequency converter, at a constant period $\Delta$ T.

2. Analog frequency converter as in Claim 1, characterised in that the comparator (3) connected at the output side of the integrator is loaded with a reference voltage (Uv), the polarity of which can be reversed synchronously with the change in the direction of integration.

3. Analog frequency converter as in Claim 1 or 2, characterised in that the constant period $\Delta$ T is derived by a frequency divider (4) from the base frequency of the analog value.

4. Analog frequency converter as in Claim 3, characterised in that a multiplier is connected in front, its first input value (u) being delivered to the input of the analog-frequency converter via a switch (If), and the second input value activating the switch (If) via a quantizer (Id) and an exclusive OR gate (Ic), with a second input of the exclusive OR gate (Ic) being activated synchronously with the change in the direction of integration.

**Revendications**

1. Convertisseur pour convertir une grandeur analogique en une fréquence, selon le procédé de compensation de charge, dans lequel le sens de l'intégration est changé périodiquement par inversion du signal d'entrée et inversion simultanée du sens du courant de référence, caractérisé en ce que la polarité du condensateur d'intégration 2b est inversée simultanément avec le changement du sens de l'intégration et que le changement du sens de l'intégration s'opère avec une période $\Delta$ T constante et en asynchronisme avec les impulsions de sortie du convertisseur analogique-fréquence.

2. Convertisseur selon la revendication 1, caractérisé en ce que le comparateur (3a) monté à la suite de l'intégrateur est alimenté avec une tension de comparaison (U$_v$) dont la polarité peut être inversée en synchronisme avec le changement du sens d'intégration.

3. Convertisseur selon la revendication 1 ou 2, caractérisé en ce que la période $\Delta$ T constante est dérivée de la fréquence fondamentale de la valeur analogique par un diviseur de fréquence (4).

4. Convertisseur selon la revendication 3, caractérisé en ce qu'il est précédé d'un multiplicateur dont une première grandeur d'entrée (U) est appliquée à travers un inverseur (If) à l'entrée du convertisseur analogique-fréquence et dont une seconde grandeur d'entrée commande l'interrupteur (If) à travers un quantificateur (Id) et une porte OU-exclusif (Ic) dont une deuxième entrée est commandée en synchronisme avec le changement du sens d'intégration.

FIG 1

FIG 2

FIG 3